# FASCICULE DE BREVET EUROPEEN

(11) **EP 4 128 380 B1**
(45) Date de publication et mention de la délivrance du brevet: **25.06.2025**
(21) Numéro de dépôt: 21713957.5
(22) Date de dépôt: 24.03.2021
(51) Int. Cl.: H10N 30/072, H10N 30/073

(54) **PROCEDE DE FABRICATION D'UNE STRUCTURE PIEZOELECTRIQUE POUR DISPOSITIF RADIOFREQUENCE ET SERVANT POUR LE TRANSFERT D'UNE COUCHE PIEZOELECTRIQUE, ET PROCEDE DE TRANSFERT D'UNE TELLE COUCHE PIEZOELECTRIQUE**
VERFAHREN ZUR HERSTELLUNG EINER PIEZOELEKTRISCHEN STRUKTUR FÜR EINE HOCHFREQUENZVORRICHTUNG UND GEEIGNET ZUR ÜBERTRAGUNG EINER PIEZOELEKTRISCHEN SCHICHT UND VERFAHREN ZUR ÜBERTRAGUNG EINER SOLCHEN PIEZOELEKTRISCHEN SCHICHT
METHOD OF MANUFACTURING A PIEZOELECTRIC STRUCTURE FOR A RADIO FREQUENCY DEVICE WHICH IS USED FOR THE TRANSFER OF A PIEZOELECTRIC LAYER, AND METHOD OF TRANSFERRING SUCH A PIEZOELECTRIC LAYER

(30) Priorité: 24.03.2020 FR 2002834
(43) Date de publication de la demande: 08.02.2023
(73) Titulaire: Soitec, 38190 Bernin (FR)
(72) Inventeur: CASTEX, Arnaud, 38100 Grenoble (FR); DOUTRE-ROUSSEL, Laurence, 38120 Fontanil Cornillon (FR); BUTAUD, Eric, 38000 Grenoble (FR); TAVEL, Brice, 38000 Grenoble (FR)
(74) Mandataire: IP Trust
(86) Numéro de dépôt international: PCT/EP2021/057620
(87) Numéro de publication internationale: WO 2021/191303

(56) Documents cités:
- WO-A1-2019/186032
- WO-A1-2019/186267
- FR-B1- 3 079 345

## Description

### DOMAINE DE L'INVENTION

La présente invention concerne un procédé de fabrication d'une structure piézoélectrique pour dispositif radiofréquence et pouvant servir pour le transfert d'une couche piézoélectrique, et procédé de transfert d'une telle couche piézoélectrique.

### ETAT DE LA TECHNIQUE

Il est connu de fabriquer un dispositif radiofréquence (RF), tel qu'un résonateur ou filtre, sur un substrat comprenant successivement, de sa base vers sa surface, un substrat support, généralement en un matériau tel que le silicium ou le sapphire, une couche intermédiaire de collage et une couche piézoélectrique.

Les filtres à ondes acoustiques de surface (« SAW », acronyme du terme anglo-saxon « Surface Acoustic Wave ») comprennent typiquement une couche piézoélectrique et deux électrodes sous la forme de deux peignes métalliques interdigités déposés sur la surface de ladite couche piézoélectrique. Selon le fonctionnement du filtre SAW l'épaisseur de la couche piézoélectrique peut être de l'ordre de quelques dizaines de nanomètres jusqu'à plusieurs dizaines de µm. Pour ces derniers il existe des modes parasites de propagation qui s'étendent dans l'épaisseur de la couche piézoélectrique et sont susceptible de se refléter à l'interface avec le substrat support sous-jacent. Ce phénomène est appelé « rattle » en anglais. Pour éviter ces modes parasites, il est connu de faire en sorte que la surface de la couche piézoélectrique située à l'interface avec la couche intermédiaire de collage soit suffisamment rugueuse pour permettre une réflexion des ondes parasites dans toutes les directions. Compte tenu de la longueur d'onde considérée de fonctionnement du résonateur, la rugosité de la surface rugueuse de la couche piézoélectrique est très élevée, de l'ordre de même grandeur que la longueur d'onde de fonctionnement (quelques µm).

La couche piézoélectrique est typiquement obtenue par transfert d'un substrat épais d'un matériau piézoélectrique (par exemple obtenu par découpe d'un lingot) sur un substrat support. Le substrat support est par exemple un substrat de silicium.

Le transfert de la couche piézoélectrique implique un collage du substrat piézoélectrique épais sur le substrat support, suivi d'un amincissement du substrat piézoélectrique épais, de sorte à ne laisser sur le substrat support qu'une couche piézoélectrique mince, de l'épaisseur souhaitée pour la fabrication du dispositif RF.

Pour une bonne adhésion du substrat piézoélectrique sur le substrat support, on procède généralement à un dépôt d'une couche d'oxyde (par exemple un oxyde de silicium SiO₂) sur chacun des deux substrats, et on colle lesdits substrats par l'intermédiaire desdites couches d'oxyde.

D'une part le matériau piézoélectrique et le matériau du substrat support présentant des coefficients de dilatation thermique très différents, la mise en œuvre d'un tel recuit engendre une déformation importante de l'assemblage.

D'autre part, le dépôt d'une couche d'oxyde sur le substrat piézoélectrique épais provoque une courbure (« bow » selon la terminologie anglo-saxonne) importante dudit substrat piézoélectrique, peu compatible avec les étapes ultérieures du procédé, qui sont adaptées à des substrats plans.

Enfin, comme mentionné plus haut, l'hétérostructure ne peut être soumise au recuit de consolidation en raison des différences de coefficients de dilatation thermique entre le substrat piézoélectrique épais et le substrat de manipulation. Or, l'absence du recuit de consolidation, l'énergie de collage des couches d'oxyde des deux substrats reste très faible, de sorte que la tenue mécanique du pseudo-substrat donneur est insuffisante. Par conséquent, une rupture au niveau de l'interface de collage peut se produire lors de l'étape de l'amincissement du substrat piézoélectrique épais.

Pour assurer une bonne adhésion entre le substrat piézoélectrique épais et le substrat support, en particulier dans le cas où le substrat piézoélectrique épais a une rugosité importante, le procédé actuel nécessite un grand nombre d'étapes telles que le dépôt de plusieurs couches d'oxyde suivi de polissage mécano-chimique (CMP, acronyme anglo-saxon du terme anglo-saxon « Chemical Mechanical Polishing ») desdites couches d'oxyde, lesdites couches d'oxyde déposé de manière alternée sur les deux faces du substrat piézoélectrique épais afin d'éviter une courbure importante rendant impossible le collage.

Le document WO2019/186267 A1 montre un procédé de transfert de couche en matériau piézoélectrique utilisant un substrat initial et un substrat intermédiaire et par effectuer une étape d'amincissement du substrat initial après avoir été assemblé au substrat intermédiaire. Les documents FR3079345 B1 et WO2019/186032 A1 concernent respectivement un procédé de fabrication d'un substrat pour dispositif radiofréquence par assemblage d'une couche piézoélectrique sur un substrat support par l'intermédiaire d'une couche électriquement isolante.

### EXPOSE DE L'INVENTION

La présente invention vise à pallier ces limitations de l'état de la technique en proposant un procédé de fabrication d'une structure piézoélectrique pour dispositif radiofréquence, pouvant aussi servir pour le transfert d'une couche piézoélectrique, et procédé de transfert d'une telle couche piézoélectrique. L'invention concerne un procédé de fabrication d'une structure piézoélectrique selon la revendication indépendante 1.

Ainsi la faible contrainte induite par le dépôt d'une couche de collage diélectrique à faible température telle que mentionnée ci-dessus inférieure ou égale à 300°C permet d'assurer une stabilité mécanique suffisante permettant des étapes d'amincissement telles que décrites dans le reste de la description ainsi que lors des étapes de packaging utilisées ultérieurement pendant la fabrication de composants.

Dans des modes de réalisation la couche de collage diélectrique comprend une couche d'oxyde de silicium déposée sur le substrat de matériau piézoélectrique par dépôt chimique en phase vapeur assisté par plasma.

Dans des modes de réalisation avantageux l'étape d'assemblage comprend un collage moléculaire entre la couche de collage diélectrique et le substrat support ou entre la couche de collage diélectrique et une couche de collage diélectrique formée sur le substrat support.

Dans des modes de réalisation avantageux l'étape d'amincissement est faite à une température inférieure à la température de dépôt de ladite couche de collage diélectrique.

Dans des modes de réalisation avantageux le substrat de matériau piézoélectrique présente une surface rugueuse adaptée pour réfléchir une onde radiofréquence.

Dans des modes de réalisation avantageux l'épaisseur de la couche de collage diélectrique est comprise entre 200 nm et 500 nm.

Dans des modes de réalisation avantageux on trouve la fourniture d'une couche de collage diélectrique sur le substrat support.

Dans des modes de réalisation avantageux l'étape d'amincissement comprend une gravure et/ou un polissage mécano-chimique.

L'invention concerne aussi un procédé de transfert d'une couche piézoélectrique sur un substrat final, comprenant la fourniture d'une structure piézoélectrique obtenue par la mise en œuvre du procédé de fabrication selon l'une quelconque des revendications précédentes, la formation d'une zone de fragilisation dans la couche de matériau piézoélectrique de manière à délimiter la couche piézoélectrique à transférer, la fourniture du substrat final, préférentiellement la formation de couches de collage diélectrique sur une face principale du substrat final et/ou la couche de matériau piézoélectrique, le collage de la couche de matériau piézoélectrique sur le substrat final, la fracture et la séparation de la structure piézoélectrique le long de la zone de fragilisation, à une température inférieure ou égale à la température de dépôt de la couche de collage diélectrique.

Dans des modes de réalisation avantageux la formation de la zone de fragilisation est effectuée par implantation d'espèces atomiques dans la couche de matériau piézoélectrique.

Dans des modes de réalisation avantageux le substrat final et le substrat support ont des coefficients de dilatation identiques.

### DESCRIPTION DES FIGURES

D'autres caractéristiques et avantages de l'invention seront mieux compris à la lecture de la description détaillée qui va suivre, en référence aux dessins annexés sur lesquels :
La figure 1 illustre un procédé de fabrication selon un mode de réalisation de l'invention ainsi qu'un substrat selon ce mode de réalisation de l'invention ;
La figure 2 illustre un procédé de fabrication selon un autre mode de réalisation de l'invention ainsi qu'un substrat selon cet autre mode de réalisation de l'invention ;
La figure 3 illustre un procédé de transfert selon un mode de réalisation de l'invention ;
La figure 4 illustre un procédé de transfert selon un autre mode de réalisation de l'invention ;

Pour favoriser la lisibilité des figures, les différentes couches ne sont pas nécessairement représentées à l'échelle.

### DESCRIPTION DETAILLEE DE MODES DE REALISATION DE L'INVENTION

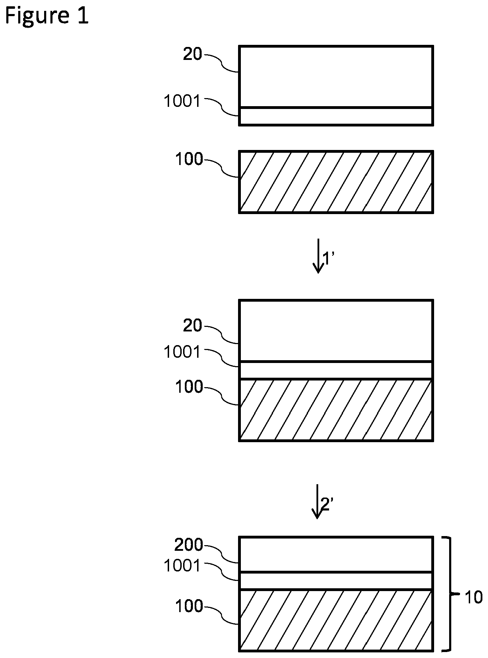

La figure 1 illustre un substrat support 100, préférentiellement de matériau silicium, sur lequel on transfère une couche de matériau piézoélectrique 200, de préférence de matériau piézoélectrique monocristallin, encore plus particulier de matériau tantalate de lithium ou niobate de lithium. D'autres matériaux de la couche de matériau piézoélectrique 200 peuvent être envisagés. La couche active 200 à être transférée peut aussi comprendre un matériau ferroélectrique, par exemple de LiTaO₃, LiNbO₃, LiAlO₃, BaTiO₃, PbZrTiO₃, KNbO₃, BaZrO₃, CaTiO₃, PbTiO₃ ou de KTaO₃.

Le substrat donneur comprenant cette couche active peut prendre la forme d'une plaquette, circulaire, de dimension normalisée, par exemple de 150 mm ou 200 mm de diamètre. Mais l'invention n'est nullement limitée à ces dimensions ou à cette forme. Le substrat donneur peut avoir été prélevé d'un lingot de matériaux ferroélectrique, ce prélèvement ayant été réalisé de manière à ce que le substrat donneur présente une orientation cristalline prédéterminée, ou encore le substrat donneur peut comprendre une couche de matériau ferroélectrique assemblé à un substrat support. L'orientation cristalline de la couche active de matériau ferroélectrique à être transférée est choisie en fonction de l'application visée. Ainsi, en ce qui concerne le matériau LiTaO₃, il est usuel de choisir une orientation comprise entre 30° et 60°XY, ou entre 40° et 50°XY, en particulier dans le cas où l'on souhaite exploiter les propriétés de la couche mince pour former un filtre SAW. En ce qui concerne le matériau LiNbO₃ il est usuel de choisir une orientation autour de 128° XY. Mais l'invention n'est nullement limitée à une orientation cristalline particulière.

Quelle que soit l'orientation cristalline du matériau ferroélectrique du substrat donneur, le procédé comprend par exemple l'introduction d'espèces (ions et/ou atomes) d'hydrogène et/ou d'hélium dans ce substrat donneur. Cette introduction peut par exemple correspondre à une implantation d'hydrogène, c'est-à-dire, un bombardement ionique d'hydrogène de la face plane du substrat donneur. De façon connue en soi, les ions implantés ont pour but de former un plan de fragilisation délimitant une première couche de matériau ferroélectrique à transférer qui est située du côté de la face et une autre partie formant le reste du substrat. La nature, la dose des espèces implantées et le type d'ions implantés ainsi que l'énergie d'implantation sont choisies en fonction de l'épaisseur de la couche que l'on souhaite transférer et des propriétés physico-chimiques du substrat donneur. Dans le cas d'un substrat donneur en LiTaO₃, on pourra ainsi choisir d'implanter une dose d'hydrogène comprise entre 1x10¹⁶ et 5x10¹⁷ at/cm² avec une énergie comprise entre 30 et 300 keV pour délimiter une première couche de l'ordre de 10 à 2000 nm.

Le substrat support 100 de matériau silicium peut aussi être remplacé par un substrat support 100 de matériau sapphire, nitrure d'aluminium (AIN) polycristallin, verre, ou tout autre matériau ayant un coefficient de dilatation thermique inférieur ou opposé au coefficient de dilatation thermique du matériau piézoélectrique de la couche de matériau piézoélectrique 200 (dans la présente invention on s'intéresse au coefficient de dilatation thermique dans un plan parallèle à la surface principale des substrats). Ainsi le substrat support 100 joue le rôle d'un raidisseur qui limite la dilatation de la structure piézoélectrique 10 lors de variation de température auxquelles elle est soumise, ce qui permet de diminuer le coefficient thermique de fréquence de la couche de matériau piézoélectrique 200, c'est-à-dire la mesure dans laquelle la fréquence d'une onde se propageant dans la couche de matériau piézoélectrique 200 varie en fonction de la température. Le silicium est particulièrement préféré car il permet d'ajouter des fonctionnalités permettant une isolation électrique pour des applications RF résultant de l'ajout d'une couche de piégeage en surface.

L'utilisation du silicium a l'avantage d'ouvrir le champ d'application des films de matériau piézoélectrique non seulement a des équipements de grande taille type 300 mm mais aussi rendre compatible l'industrie microélectronique pour laquelle les exigences en terme d'acceptance sur la ligne de production de matériau exotique autre que silicium, en particulier tantalate de lithium ou niobate de lithium, sont élevées. On peut ainsi aussi envisager l'intégration de composants obtenus ou fabriqué dans la couche de matériau ferroélectrique voir piézoélectrique tels que des filtres SAW et/ou BAW avec des composants obtenus ou formés dans le substrat silicium tels que des transistors, amplificateur de puissance ou encore des commutateurs réseau (en terminologie anglosaxonne « switch »), ainsi réduisant les pertes dans les interconnections entre différents type de composants et rendant plus compact un tel système intégrant plusieurs composants.

La figure 1 représente schématiquement l'étape d'assemblage 1' d'un substrat de matériau piézoélectrique 20 sur le substrat support 100, préférentiellement de matériau silicium. L'étape d'assemblage 1' du substrat de matériau piézoélectrique 20 sur le substrat support 100, préférentiellement de matériau silicium, se fait préférentiellement par une étape d'adhésion moléculaire. Cette étape d'adhésion moléculaire comprend une étape de collage, préférentiellement à température ambiante, et peut être suivie d'un recuit de consolidation de l'interface de collage.

Il est aussi représenté schématiquement le dépôt d'une couche de collage 1001 diélectrique sur une seule face du substrat de matériau piézoélectrique 20, avant l'étape d'assemblage 1' du substrat de matériau piézoélectrique 20 sur le substrat support 100 par l'intermédiaire de cette couche de collage 1001 diélectrique. Le dépôt de cette couche de collage 1001 diélectrique se fait à une température inférieure ou égale à 300°C. De manière générale la température de dépôt de la couche de collage 1001 diélectrique est choisie telle que la déformation de courbure (en terminologie anglosaxonne « bow ») induite par la différence de coefficient de dilatation thermique entre le substrat de matériau piézoélectrique 20 et la couche de collage 1001 diélectrique reste compatible avec une étape de collage moléculaire, l'ensemble du substrat de matériau piézoélectrique 20 et la couche de collage 1001 diélectrique présentant une courbure inférieur ou égale à 100 µm. L'épaisseur de la couche de collage 1001 diélectrique est à considérer. Sur la gamme d'épaisseur envisagée variant entre 200 nm et 500 nm, une température de dépôt inférieur ou égale à 300 °C montre de bons résultats. Il a été constaté que non seulement la courbure (80 à 90 µm pour une couche de collage 1001 diélectrique de 500 nm) reste en dessous de la valeur seuil compatible avec un collage moléculaire (autour de 100 µm) mais qu'aussi la nature de la couche de collage 1001 diélectrique est telle que l'énergie de collage obtenue entre la couche de collage 1001 diélectrique et le substrat support 100 est améliorée. Les énergies de collage peuvent ainsi atteindre des valeurs élevées supérieur à 1J/m². Ces énergies sont suffisamment élevées pour permettre une tenue mécanique stable lors des étapes ultérieures telles que l'étape d'amincissement ou d'un recuit de consolidation.

L'étape d'adhésion moléculaire est de préférence réalisée à température ambiante, soit environ 20 °C. Il est cependant possible de réaliser ce collage direct à chaud à une température comprise entre 20 °C et 50 °C. De plus, l'étape de collage est avantageusement effectuée à basse pression, c'est-à-dire à une pression inférieure ou égale à 5 mTorr, soit 0,66661 Pa (1 Torr vaut exactement 101325/760 pascals, soit environ 133,322 Pa), ce qui permet de désorber l'eau des surfaces formant l'interface de collage. Réaliser l'étape de collage sous vide permet d'améliorer encore davantage la désorption de l'eau à l'interface de collage.

Dans un mode de réalisation avantageux, le substrat de matériau piézoélectrique 20 présente une surface rugueuse adaptée pour réfléchir une onde radiofréquence. Par « surface rugueuse » on entend dans le présent texte une surface dont la rugosité est du même ordre de grandeur que la longueur d'onde des ondes RF destinées à se propager dans la couche piézoélectrique du résonateur ou filtre, de manière à permettre la réflexion des ondes parasites dans toutes les directions pour qu'elles ne contribuent plus au signal de sorti du résonateur ou filtre en question. Dans le contexte de la présente invention, la rugosité d'une telle surface est comprise entre 1,0 et 1,8 µm mesurée en crête-à-creux (en terminologie anglosaxonne « peak to valley »). Pour combler cette rugosité la couche de collage 1001 diélectrique a une épaisseur supérieure à la rugosité, la planéité est obtenue par une étape de gravure chimique et/ou mécanique.

De manière préférentielle, la couche de collage 1001 diélectrique comprend une couche d'oxyde de silicium déposée sur le substrat de matériau piézoélectrique 20, préférentiellement par dépôt chimique en phase vapeur assisté par plasma.

Selon un autre mode de réalisation, la couche de collage 1001 diélectrique est une couche d'oxyde de silicium, ou une couche de nitrure de silicium, ou une couche comprenant une combinaison de nitrure et d'oxyde de silicium, ou une superposition d'au moins une couche d'oxyde et d'une couche de nitrure de silicium, préférentiellement obtenue par dépôt chimique en phase vapeur assisté par plasma.

Dans un mode de réalisation avantageux un recuit de consolidation de l'interface de collage est effectué pour renforcer la tenue mécanique de la structure piézoélectrique. Ce recuit est effectué à une température inférieure à la température de dépôt de ladite couche de collage 1001 diélectrique, et permet ainsi d'augmenter l'énergie de collage sans pour autant engendrer de défaut à l'interface de collage due à la présence d'impuretés quelconques (tel que l'hydrogène) et leur dégazage et migration vers cette interface lors d'un tel recuit. Le recuit de consolidation est normalement fait à des températures inférieures ou égales à 300°C, pendant une durée variant de quelques minutes pouvant aller jusqu'à quelques heures.

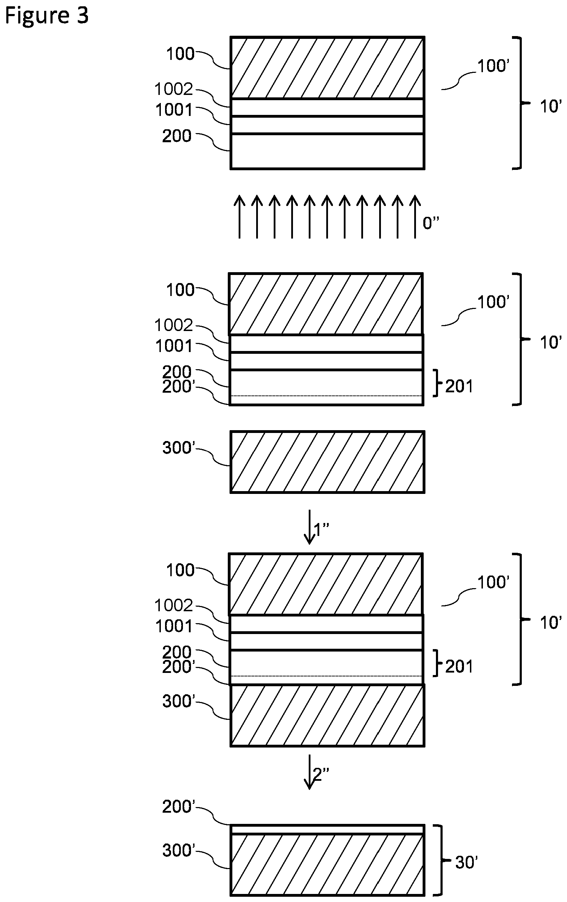

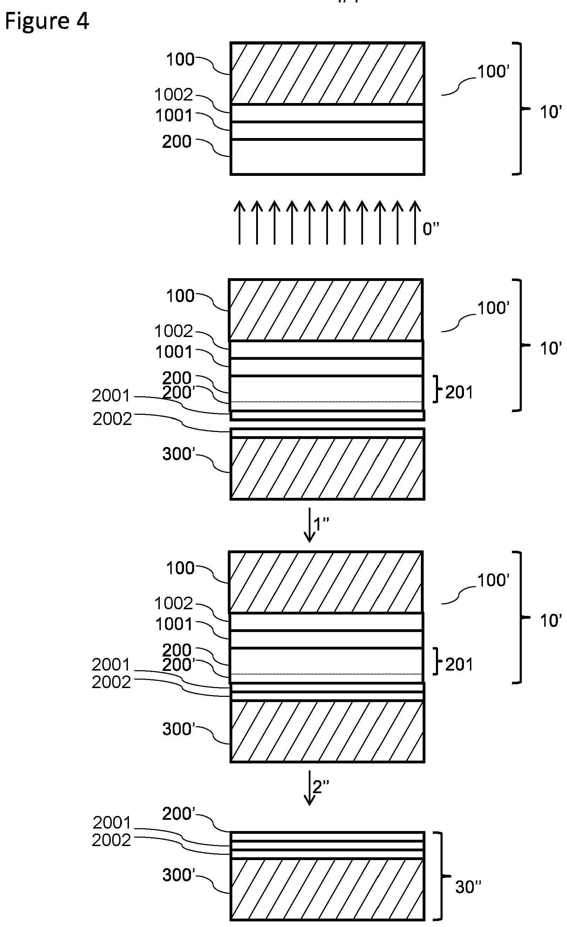

Comme représenté schématiquement dans la figure 1 il suit une étape d'amincissement 2' du substrat de matériau piézoélectrique 20 après avoir été assemblé sur le substrat support 100. La figure 1 représente schématiquement l'étape d'amincissement 2' qui peut être mise en œuvre par exemple par gravure chimique et/ou mécanique (polissage, meulage, fraisage, ..). Ainsi on peut obtenir la couche de matériau piézoélectrique 200. L'étape d'amincissement peut aussi consister à appliquer la méthode SmartCut^{™}. Cette méthode est illustré schématiquement dans les figures 3 et 4 et consiste en la formation d'une zone de fragilisation dans la couche à transférer de manière à délimiter la couche à transférer de la couche restante du substrat choisi pour le transfert, la fourniture d'un substrat receveur sur lequel on transfère la couche à transférer, une étape d'assemblage de la couche à transférer sur le substrat receveur généralement par collage moléculaire, puis une étape de détachement qui comprend la fracture et la séparation le long de la zone de fragilisation ainsi formant une hétérostructure comprenant la couche à transférer sur le substrat receveur. L'étape d'amincissement est faite de manière générale à une température inférieure à la température de dépôt de ladite couche de collage 1001 diélectrique ce qui permet d'éviter la présence de défauts à l'interface de collage mentionnés ci-dessus due à la présence d'impuretés quelconques (tel que l'hydrogène) et leur dégazage et migration vers cette interface lors d'une telle étape d'amincissement.

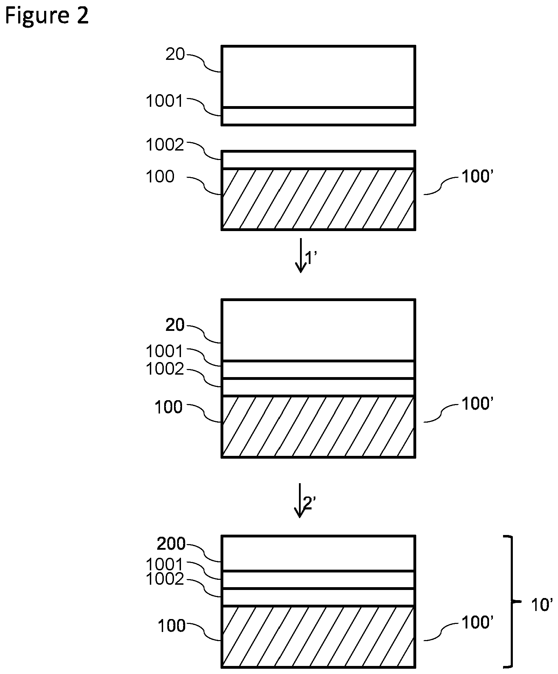

Le procédé de fabrication représenté schématiquement dans la figure 2 diffère du procédé de fabrication représenté schématiquement dans la figure 1 en ce que avant l'étape d'assemblage 1' une couche de collage 1002 diélectrique est formée sur le substrat de support 100 qui est ainsi présente dans la structure piézoélectrique 10' obtenue par le procédé de fabrication selon l'invention. Selon le matériau choisi pour le substrat support 100 cette couche de collage 1002 diélectrique est formée de telle manière à permettre un collage moléculaire entre l'ensemble du substrat de matériau piézoélectrique 20 et de la couche de collage 1001 diélectrique et l'ensemble 100' du substrat support 100 et de la couche de collage 1002 diélectrique. La courbure de l'ensemble 200' reste ainsi inférieur ou égale à 100 µm.

De manière préférentielle, la couche de collage 1002 diélectrique comprend une couche d'oxyde de silicium. Dans le cas d'un substrat support 100 en matériau silicium il peut s'agir d'un oxyde thermique mais l'invention n'est pas limitée à ceci. De manière non-limitative il peut aussi être obtenu par un dépôt chimique en phase vapeur assisté par plasma.

La figure 3 représente schématiquement un mode de réalisation d'un procédé de transfert d'une couche piézoélectrique 200' sur un substrat final 300', comprenant la fourniture d'une structure piézoélectrique 10' (obtenu selon le procédé représenté schématiquement dans la figure 2 sachant que l'invention n'est pas limité à ce mode de réalisation), la formation d'une zone de fragilisation 0" dans la couche de matériau piézoélectrique 200 de manière à délimiter la couche piézoélectrique 200' à transférer de la couche restante 201 de la couche de matériau piézoélectrique 200, la fourniture du substrat final 300', une étape d'assemblage 2" de la couche de matériau piézoélectrique 200 sur le substrat final 300', une étape de détachement 2" qui comprend la fracture et la séparation de la structure piézoélectrique 10' le long de la zone de fragilisation ainsi formant la hétérostructure 30' comprenant la couche piézoélectrique 200' sur le substrat final 300'. L'étape de détachement se fait préférentiellement à une température inférieure ou égale à la température de dépôt de la couche de collage 1001 diélectrique, préférentiellement à une température inférieure ou égale à 300°C.

Le procédé de transfert représenté schématiquement dans la figure 4 diffère du procédé de transfert représenté schématiquement dans la figure 3 en ce que avant l'étape d'assemblage 1" une couche de collage 2001 diélectrique est formée sur la structure piézoélectrique 10' et une couche de collage 2002 diélectrique est formée sur le substrat final 300', ces deux couches de collage 2001 et 2002 diélectrique sont ainsi présentes dans la hétérostructure 30" obtenue par le procédé de transfert selon l'invention.

L'épaisseur de la couche diélectrique de la structure finale est ainsi la somme des épaisseurs des deux couches de collage diélectrique. Dans le cas où l'épaisseur de la couche diélectrique de la structure finale doit respecter une certaine gamme de valeur on obtient une certaine flexibilité dans la fabrication de ces couches soit sur la structure piézoélectrique soit sur le substrat final. Par exemple le substrat final pourrait déjà comporter des composants tels que mentionnés auparavant et ainsi ne pourrait pas dépasser un certain budget thermique afin de ne pas détériorer ces composants. Il est ainsi possible de former une épaisseur plus élevée de couche diélectrique sur la structure piézoélectrique que sur le substrat final.

L'invention n'est pas limitée à ceci et il peut y avoir uniquement la formation d'une des couches de collage diélectrique, soit sur la structure piézoélectrique 10' soit sur le substrat final 300'.

L'étape d'assemblage 1" de la structure piézoélectrique 10' sur le substrat final 300', préférentiellement de matériau silicium, se fait préférentiellement par une étape d'adhésion moléculaire. Cette étape d'adhésion moléculaire comprend une étape de collage, préférentiellement à température ambiante, et peut être suivie d'un recuit de consolidation de l'interface de collage.

Pour les procédés de transfert représentés schématiquement dans la figure 3 et 4, la formation de la zone de fragilisation 0" est effectuée par implantation d'espèces atomiques dans la couche de matériau piézoélectrique 200. De manière générale l'étape d'implantation 0" se fait avec des ions hydrogène. Une alternative intéressante bien connue de l'homme de l'art consiste à remplacer tout ou partie des ions hydrogène par des ions helium.

Pour une couche de matériau piézoélectrique 200 de tantalate de lithium une dose d'implantation d'hydrogène sera typiquement comprise entre 6x10¹⁶ cm⁻² et 1x10¹⁷ cm⁻². L'énergie d'implantation sera typiquement comprise entre 50 à 170 keV. Ainsi le détachement se fait typiquement à des températures entre 150 et 300 °C. On obtient ainsi des épaisseurs de la couche piézoélectrique 200' de l'ordre de 10 nm à 500 nm.

Le substrat final 300' est le substrat support 100 peuvent, de manière avantageuse, avoir un coefficient de dilatation thermique identique, ou au moins très proche, ce qui permet une meilleur tenue mécanique et moins de déformation lors de recuit de consolidation d'interface de collage. Les deux substrats peuvent être de nature identique, substantiellement fait de silicium en dehors des couches de collage diélectrique ou d'une couche de piégeage éventuellement présente. Ces dernières n'ont pas une épaisseur suffisante pour influencer de manière significative le bénéfice de la structure « sandwich » ayant un substrat final 300' et un substrat support 100 de même matériau.

Juste après l'opération de détachement, des étapes technologiques additionnelles sont avantageusement ajoutées dans le but soit de renforcer l'interface de collage, soit de récupérer une bonne rugosité, soit de guérir les défauts éventuellement générés pendant l'étape d'implantation (ou encore pour préparer la surface à la reprise d'autres étapes de procédé telles que la formation d'électrodes pour le dispositif de type SAW par exemple). Ces étapes sont par exemple un polissage, une gravure chimique (humide ou sèche), un recuit, un nettoyage chimique. Ils peuvent être utilisés seuls ou en combinaison que l'homme de l'art saura ajuster.

Dans des modes de réalisations avantageux, le substrat support 100 et/ou le substrat final 300' peuvent être un substrat en silicium présentant une résistivité électrique supérieure à 1 k.ohm.cm. Ce substrat support 100 et/ou substrat final 300' peut également comporter une couche de piégeage de charges disposée en surface de ce substrat en silicium destinée à être assemblée. La couche de piégeage peut comprendre du silicium polycristallin non dopé. Dans certaines circonstances, et notamment lorsque la couche de piégeage présente une épaisseur suffisante, par exemple supérieure à 30 µm, le substrat de base en silicium peut présenter une résistivité standard, inférieur à 1 k.ohm.cm. D'une manière générale, il s'agit d'une couche non-cristalline présentant des défauts structurels tels que des dislocations, des joints de grains, des zones amorphes, des interstices, des inclusions, des pores... Ces défauts structurels forment des pièges pour les charges susceptibles de circuler dans le matériau, par exemple au niveau de liaisons chimiques non complètes ou pendantes. On prévient ainsi la conduction dans la couche de piégeage qui présente en conséquence une résistivité élevée. De manière avantageuse, et pour des raisons de simplicité de mise en œuvre, cette couche de piégeage est formée d'une couche de silicium polycristallin. Son épaisseur, notamment lorsqu'elle est formée sur un substrat de base en silicium électriquement résistif, peut être comprise entre 0,3 µm à 3 µm. Mais d'autres épaisseurs inférieures ou supérieures à cet intervalle sont tout à fait envisageables, selon le niveau de performance RF attendu. Afin de chercher à préserver la qualité polycristalline de cette couche au cours des traitements thermiques que peut subir le substrat support 100 ou le substrat final 300', on peut avantageusement prévoir une couche amorphe, en dioxyde de silicium par exemple, sur ce substrat avant le dépôt de la couche de piégeage de charges. On peut alternativement former la couche de piégeage par une implantation d'espèce lourde, tel que de l'argon, dans une épaisseur superficielle du substrat, afin d'y former les défauts structurels constituant les pièges électriques. On peut également former cette couche par porosification d'une épaisseur superficielle du substrat.

## Revendications

1. Procédé de fabrication d'une structure piézoélectrique (10, 10') pour dispositif radiofréquence, ledit procédé étant **caractérisé en ce qu'**il comprend la fourniture d'un substrat de matériau piézoélectrique (20), la fourniture d'un substrat support (100), le dépôt d'une couche de collage (1001) diélectrique à une température inférieure ou égale à 300°C sur une seule face du substrat de matériau piézoélectrique (20), une étape d'assemblage (1') du substrat de matériau piézoélectrique (20) sur le substrat support (100) par l'intermédiaire de la couche de collage (1001) diélectrique, une étape d'amincissement (2') pour former la structure piézoélectrique (10, 10') comprenant une couche de matériau piézoélectrique (200) assemblé à un substrat support (100), comprenant en outre un recuit de consolidation de l'interface de collage à une température inférieure à la température de dépôt de ladite couche de collage (1001) diélectrique.

2. Procédé selon la revendication précédente dans lequel la couche de collage (1001) diélectrique comprend une couche d'oxyde de silicium déposée sur le substrat de matériau piézoélectrique (20) par dépôt chimique en phase vapeur assisté par plasma.

3. Procédé selon l'une quelconque des revendications précédentes, dans lequel l'étape d'assemblage (1') comprend un collage moléculaire entre la couche de collage (1001) diélectrique et le substrat support (100) ou entre la couche de collage (1001) diélectrique et une couche de collage (1002) diélectrique formée sur le substrat support (100).

4. Procédé selon l'une quelconque des revendications précédentes, dans lequel l'étape d'amincissement (2') est faite à une température inférieure à la température de dépôt de ladite couche de collage (1001) diélectrique.

5. Procédé selon l'une quelconque des revendications précédentes, dans lequel le substrat de matériau piézoélectrique (20) présente une surface rugueuse adaptée pour réfléchir une onde radiofréquence.

6. Procédé selon l'une quelconque des revendications précédentes, dans lequel l'épaisseur de la couche de collage (1001) diélectrique est comprise entre 200 nm et 500 nm.

7. Procédé selon l'une quelconque des revendications précédentes, comprenant en outre la fourniture d'une couche de collage (1002) diélectrique sur le substrat support (100).

8. Procédé selon l'une quelconque des revendications précédentes, dans lequel l'étape d'amincissement (2') comprend une gravure et/ou un polissage mécano-chimique.

9. Procédé de transfert d'une couche piézoélectrique (200') sur un substrat final (300'), comprenant la fourniture d'une structure piézoélectrique (10, 10') obtenue par la mise en œuvre du procédé de fabrication selon l'une quelconque des revendications précédentes, la formation d'une zone de fragilisation (0") dans la couche de matériau piézoélectrique (200) de manière à délimiter la couche piézoélectrique (200') à transférer, la fourniture du substrat final (300'), préférentiellement la formation de couches de collage (2001, 2002) diélectrique sur une face principale du substrat final (300') et/ou la couche de matériau piézoélectrique (200), une étape d'assemblage (1") par collage de la couche de matériau piézoélectrique (200) sur le substrat final (300'), une étape de détachement (2") comprenant la fracture et la séparation de la structure piézoélectrique (10, 10') le long de la zone de fragilisation, à une température inférieure ou égale à la température de dépôt de la couche de collage (1001) diélectrique.

10. Procédé selon la revendication précédente, dans lequel la formation de la zone de fragilisation est effectuée par implantation d'espèces atomiques dans la couche de matériau piézoélectrique (200).

11. Procédé selon l'une des revendications 9 ou 10, dans lequel le substrat final (300') et le substrat support (100) ont des coefficients de dilatation identiques.

## Patentansprüche

1. Verfahren zur Herstellung einer piezoelektrischen Struktur (10, 10') für eine Hochfrequenzvorrichtung, wobei das Verfahren **dadurch gekennzeichnet ist, dass** es die Bereitstellung eines Substrats aus piezoelektrischem Material (20), die Bereitstellung eines Trägersubstrats (100), das Abscheiden einer dielektrischen Klebeschicht (1001) bei einer Temperatur von weniger als oder gleich 300 °C auf einer einzigen Seite des Substrats aus piezoelektrischem Material (20), einen Schritt des Zusammenfügens (1') des Substrats aus piezoelektrischem Material (20) auf das Trägersubstrat (100) mithilfe der dielektrischen Klebeschicht (1001) umfasst, einen Verdünnungsschritt (2'), um die piezoelektrische Struktur (10, 10') zu bilden, umfassend eine Schicht aus piezoelektrischem Material (200), die mit einem Trägersubstrat (100) zusammengefügt ist, weiter umfassend ein Konsolidierungsglühen der Klebeschnittstelle bei einer Temperatur unter der Abscheidetemperatur der dielektrischen Klebeschicht (1001).

2. Verfahren nach dem vorstehenden Anspruch, wobei die dielektrische Klebeschicht (1001) eine Schicht aus Siliziumoxid umfasst, die auf dem Substrat aus piezoelektrischem Material (20) durch plasmaunterstützte chemische Dampfabscheidung abgeschieden wurde.

3. Verfahren nach einem der vorstehenden Ansprüche, wobei der Schritt des Zusammenfügens (1') eine molekulare Verklebung zwischen der dielektrischen Klebeschicht (1001) und dem Trägersubstrat (100) oder zwischen der dielektrischen Klebeschicht (1001) und einer auf dem Trägersubstrat (100) gebildeten dielektrischen Klebeschicht (1002) umfasst.

4. Verfahren nach einem der vorstehenden Ansprüche, wobei der Verdünnungsschritt (2') bei einer Temperatur durchgeführt wird, die niedriger ist als die Abscheidetemperatur der dielektrischen Klebeschicht (1001).

5. Verfahren nach einem der vorstehenden Ansprüche, wobei das Substrat aus piezoelektrischem Material (20) eine raue Oberfläche aufweist, die geeignet ist, eine Hochfrequenzwelle zu reflektieren.

6. Verfahren nach einem der vorstehenden Ansprüche, wobei die Dicke der dielektrischen Klebeschicht (1001) zwischen 200 nm und 500 nm liegt.

7. Verfahren nach einem der vorstehenden Ansprüche, weiter umfassend die Bereitstellung einer dielektrischen Klebeschicht (1002) auf dem Trägersubstrat (100).

8. Verfahren nach einem der vorstehenden Ansprüche, wobei der Verdünnungsschritt (2') ein Ätzen und/oder ein mechanisch-chemisches Polieren umfasst.

9. Verfahren zum Übertragen einer piezoelektrischen Schicht (200') auf ein Endsubstrat (300'), umfassend die Bereitstellung einer piezoelektrischen Struktur (10, 10'), die durch die Durchführung des Herstellungsverfahrens nach einem der vorstehenden Ansprüche erhalten wird, die Bildung einer Versprödungszone (0") in der piezoelektrischen Materialschicht (200) derart, dass die zu übertragende piezoelektrische Schicht (200') abgegrenzt wird, die Bereitstellung des Endsubstrats (300'), vorzugsweise die Bildung von dielektrischen Klebeschichten (2001, 2002) auf einer Hauptseite des Endsubstrats (300') und/oder der piezoelektrischen Materialschicht (200), einen Schritt des Zusammenfügens (1") durch Verkleben der piezoelektrischen Materialschicht (200) auf das Endsubstrat (300'), einen Ablöseschritt (2"), der das Brechen und Trennen der piezoelektrischen Struktur (10, 10') entlang der Versprödungszone umfasst, bei einer Temperatur kleiner oder gleich der Abscheidetemperatur der dielektrischen Klebeschicht (1001).

10. Verfahren nach dem vorstehenden Anspruch, wobei die Bildung der Versprödungszone durch Implantation von Atomspezies in der piezoelektrischen Materialschicht (200) erfolgt.

11. Verfahren nach einem der Ansprüche 9 oder 10, wobei das Endsubstrat (300') und das Trägersubstrat (100) identische Ausdehnungskoeffizienten aufweisen.

## Claims

1. Method for manufacturing a piezoelectric structure (10, 10') for a radio-frequency device, said method being **characterized in that** it comprises the provision of a substrate of piezoelectric material (20), the provision of a substrate carrier (100), the deposition of a dielectric bonding layer (1001) at a temperature less than or equal to 300°C on a single face of the piezoelectric material substrate (20), a step of assembling (1') the piezoelectric material substrate (20) on the substrate carrier (100) by means of the dielectric bonding layer (1001), a thinning step (2') for forming the piezoelectric structure (10, 10') comprising a piezoelectric material layer (200) assembled to a substrate carrier (100), further comprising a consolidation anneal of the bonding interface at a temperature less than the deposition temperature of said dielectric bonding layer (1001).

2. The method according to the preceding claim, wherein the dielectric bonding layer (1001) comprises a layer of silicon oxide deposited on the piezoelectric material substrate (20) by plasma-assisted chemical vapour deposition.

3. The method according to any one of the preceding claims, wherein the assembly step (1') comprises a molecular bonding between the dielectric bonding layer (1001) and the substrate carrier (100) or between the dielectric bonding layer (1001) and a dielectric bonding layer (1002) formed on the substrate carrier (100).

4. The method according to any one of the preceding claims, wherein the thinning step (2') is carried out at a temperature less than the deposition temperature of said dielectric bonding layer (1001).

5. The method according to any one of the preceding claims, wherein the piezoelectric material substrate (20) has a rough surface, adapted to reflect a radio-frequency wave.

6. The method according to any one of the preceding claims, wherein the thickness of the dielectric bonding layer (1001) is comprised between 200 nm and 500 nm.

7. The method according to any one of the preceding claims, further comprising the provision of a dielectric bonding layer (1002) on the substrate carrier (100).

8. The method according to any one of the preceding claims, wherein the thinning step (2') comprises etching and/or chemical-mechanical polishing.

9. Method for transferring a piezoelectric layer (200') onto a final substrate (300'), comprising the provision of a piezoelectric structure (10, 10') obtained by carrying out the manufacturing method according to any one of the preceding claims, the formation of a weakening zone (0") in the layer of piezoelectric material (200) such as to delimit the piezoelectric layer (200') to be transferred, the provision of the final substrate (300'), preferably the formation of dielectric bonding layers (2001, 2002) on a main face of the final substrate (300') and/or the layer of piezoelectric material (200), an assembly step (1") by bonding the layer of piezoelectric material (200) to the final substrate (300'), a detachment step (2") comprising the fracture and separation of the piezoelectric structure (10, 10') along the weakening zone, at a temperature less than or equal to the deposition temperature of the dielectric bonding layer (1001).

10. The method according to the preceding claim, wherein the formation of the weakening zone is carried out by implantation of atomic species in the layer of piezoelectric material (200).

11. The method according to any one of claims 9 or 10, wherein the final substrate (300') and the substrate carrier (100) have identical expansion coefficients.
